# FASCICULE DE BREVET EUROPEEN

(11) **EP 0 820 128 B1**
(45) Date de publication et mention de la délivrance du brevet: **24.10.2001**
(21) Numéro de dépôt: 97401694.1
(22) Date de dépôt: 15.07.1997
(51) Int. Cl.: H01S 3/06, B23B 31/00

(54) **Procédé d'assemblage de deux structures et dispositif obtenu par le procédé**
Verfahren zum Zusammensetzen zweier Strukturen und durch dieses Verfahren hergestellte Vorrichtung
Method of assambling two structures and device obtained by using this method

(30) Priorité: 17.07.1996 FR 9608943
(43) Date de publication de la demande: 21.01.1998
(73) Titulaire: COMMISSARIAT A L'ENERGIE ATOMIQUE, 75015 Paris (FR)
(72) Inventeur: Rabarot, Marc, 38170 Seyssinet (FR); Fulbert, Laurent, 38500 Voiron (FR)
(74) Mandataire: Des Termes, Monique

(56) Documents cités:
- EP-A- 0 653 824
- US-A- 5 461 637
- US-A- 5 488 619
- US-A- 5 513 204
- US-A- 5 516 388
- YAMADA A ET AL: "SOI by wafer bonding with spin-on glass as adhesive" ELECTRONICS LETTERS, 2 JAN. 1987, UK, vol. 23, no. 1, ISSN 0013-5194, pages 39-40, XP002029273
- YAMADA A ET AL: "Bonding silicon wafer to silicon nitride with spin-on glass as adhesive" ELECTRONICS LETTERS, 26 MARCH 1987, UK, vol. 23, no. 7, ISSN 0013-5194, pages 314-315, XP002029274

## Description

L'invention concerne les techniques d'assemblage de deux structures, en particulier de structures devant présenter une bonne tenue mécanique et des faces en regard parallèles.

L'invention s'applique notamment au domaine de l'optronique, par exemple aux microlasers solides pompés par diodes et aux composants de microoptique associés.

L'invention concerne donc également le domaine des microlasers ou encore des cavités microlasers, dont le milieu actif est solide.

Les microlasers ont de nombreuses applications, dans des domaines aussi variés que l'industrie automobile, l'environnement, l'instrumentation scientifique, la télémétrie.

La structure d'un microlaser est celle d'un empilement de multicouches.

Le milieu actif laser est constitué par un matériau de faible épaisseur (entre 150-1000 µm) et de petites dimensions (quelques mm²), sur lequel des miroirs diélectriques de cavité sont directement déposés. Ce milieu actif peut être pompé par une diode laser III-V qui est soit directement hybridée sur le microlaser, soit couplée à ce dernier par fibre optique. La possibilité d'une fabrication collective utilisant les moyens de la microélectronique autorise une production de masse de ces microlasers.

### Art antérieur

Pour assembler deux structures, on utilise, de manière classique, un film de colle entre les deux structures. Mais cette méthode ne permet pas de garantir à la fois une bonne tenue mécanique de l'ensemble, ainsi qu'un bon parallélisme entre les deux faces des structures.

Le document US-A-5 516 388 décrit l'assemblage d'une couche de diamant avec une surface irrégulière sur un substrat.

Le joint est formé par une couche de Sol Gel.

Dans le cas d'un microlaser, le document EP-653 824 (US-5 495 494) décrit un procédé de réalisation pour un microlaser solide à déclenchement passif par absorbant saturable : l'absorbant saturable est déposé directement sur le milieu actif solide, sous la forme d'une couche mince, par la technique d'épitaxie en phase liquide (EPL). Le procédé est proposé pour eviter la collage entre les composants d'un microlaser.

Mais la technique EPL ne peut pas être utilisée pour tous les matériaux. En particulier, lorsque le milieu actif du laser n'a pas de structure cristalline (c'est le cas du verre dopé avec des ions erbium et/ou ytterbium)l'EPL est inutilisable. De même, lorsqu'on associe à un milieu actif pour cavité microlaser un moyen de déclenchement actif de la cavité, par exemple un élément électrooptique, comme décrit dans l'article de J.J. Zayhowski intitulé "diode-pumped microchip lasers electro-optically Q-switched at high pulse repetition rates" paru dans Optics Letters, vol. 17, n°17, pages 1201-1203, 1992, la technique EPL n'est pas utilisable. Il en va de même lorsqu'on associe à une cavité microlaser un matériau non linéaire, tel qu'un doubleur ou un tripleur de fréquence, ou bien un oscillateur paramétrique optique (OPO).

Pour tous ces cas particuliers, les procédés de fabrication développés mettent en oeuvre une étape d'hybridation entre deux plaquettes de matériau, par exemple une plaquette du matériau constitutif du milieu actif laser, et une plaquette de matériau constitutif de moyens de déclenchement actif ou du matériau non-linéaire. Les deux plaquettes sont collées l'une à l'autre, à l'aide d'une colle optique, d'indice de réfraction connu (par exemple environ égale à 1,5). Les surfaces à coller sont préalablement polies, en général avec une rugosité de l'ordre de quelques angströms RMS (moyenne quadratique), et elles présentent un écart de planéité localisée meilleur que λ/10 (100 nm à λ=1,06 µm). Après réalisation des autres étapes (par exemple formation des couches de miroir) les plaquettes de matériau sont découpées de façon à former des cavités microlaser individuelles. La cavité est ensuite couplée avec les moyens de pompage, par exemple une diode laser III-V. Le microlaser ainsi obtenu ne fonctionne bien que si les pertes optiques introduites par la nature et l'épaisseur de la colle sont faibles et si le parallélisme des faces, aux interfaces des plaquettes, est également faible, inférieur à environ 10" d'arc. De plus, le collage doit présenter une bonne adhérence pour permettre la découpe en puces de l'assemblage des plaquettes, cette découpe étant réalisée en général à l'aide d'une scie à lame diamantée.

Quelles que soient les structures assemblées, et en particulier dans le cas d'un microlaser, l'assemblage par colle présente plusieurs inconvénients :
- tout d'abord, l'épaisseur du joint de colle dépend de la quantité et du site d'application de la colle au départ, ainsi que de la pression appliquée,
- on ne sait pas, a priori, ajuster le parallélisme entre deux surfaces. Une solution expérimentée consiste à réduire l'épaisseur de colle à l'ordre de grandeur des défauts de planéité, mais sans véritable contrôle possible. Le résultat présente donc un caractère aléatoire, ce qui est un problème pour une fabrication collective, comme par exemple celle mise en oeuvre dans le cas de cavités microlaser.
- La colle peut se transformer au cours du temps (en particulier dans le cas d'un microlaser, sous l'influence du rayonnement ou d'un échauffement) et modifier la tenue mécanique ainsi que le parallélisme de l'assemblage et des composants ; la colle peut également dégazer localement dans une zone active, et introduire ainsi des pertes supplémentaires.

Il se pose donc le problème de réaliser l'assemblage de deux structures, en particulier l'assemblage de deux composants pour cavité microlaser, la technique d'assemblage permettant à la fois de maîtriser le parallélisme et la tenue mécanique des deux structures, ou des deux composants, et permettant de garantir au mieux le vieillissement de l'ensemble.

### Exposé de l'invention

L'invention a pour un objet procédé d'assemblage de deux structures, comportant :
- la formation, sur au moins une des structures, de plots en un matériau fluable et mouillable sur les deux structures, par dépôt d'une couche dudit matériau et gravure de ce dernier,
- le positionnement des deux structures de manière à ce que les plots se trouvent à leur interface,
- l'assemblage des deux structures, par chauffage des plots, pour les faire fluer, et par la réalisation d'un contact intime des deux structures.

On assure ainsi un assemblage des deux structures par contact intime avec une substance adhésive. L'utilisation de plots en un matériau fluable et mouillable, à l'interface des deux structures, permet de réaliser, par écrasement lors du rapprochement des deux structures, un joint qui garantit le maintien mécanique de l'assemblage. Ainsi, les deux structures peuvent ensuite être découpées. Dans le cas de structures dans lesquelles on souhaite réaliser des cavités microlasers, la découpe peut avoir lieu à l'aide d'une scie diamantée, sans que l'opération de découpe ne soit fatale à la bonne tenue mécanique de l'ensemble des deux structures assemblées ainsi.

On entend par contact intime des deux surfaces aussi bien un simple contact entre lesdites surfaces qu'un contact mettant en présence des forces de type adhésion moléculaire telles que des forces de Van der Walls ou l'utilisation de substances adhésives (colle, résine, ...).

Cette méthode d'assemblage permet de garantir un très bon contrôle du parallélisme des faces en contact. En effet, classiquement si on l'applique à des plaques entières de composants, par exemple de composants de microlaser ou de composants microoptiques, destinés à être ensuite découpés, l'opération de découpe peut être fatale à la bonne tenue des assemblages élémentaires réalisés, car la surface de contact (délimitée par les traits de découpe) est en général très faible devant l'épaisseur desdits assemblages élémentaires. De plus, les matériaux à mettre en contact ne sont pas forcément compatibles directement entre eux, suivant le type d'application visé : les surfaces peuvent présenter des différences de natures physico-chimiques, les matériaux en présence peuvent présenter des différences de coefficients thermomécaniques.

Ainsi, le procédé d'assemblage selon l'invention permet d'obtenir simultanément un bon parallélisme et une bonne tenue mécanique.

L'invention a également pour objet un procédé à assemblage de deux structures, comportant :
- la formation d'au moins un plot espaceur dans une première des deux structures, ce(s) plot(s) espaceur(s) définissant, sur ses bords, un, ou des, caisson(s) latéral (latéraux), chaque caisson latéral présentant un fond,
- la formation, sur le fond d'au moins un caisson latéral, d'un joint en un matériau fluable et mouillable sur les deux structures,
- le positionnement des deux structures de manière à ce que le joint se trouve à leur interface,
- l'assemblage des deux structures par chauffage des joints, pour les faire fluer, et la réalisation d'un contact intime des deux structures.

On entend par joint aussi bien un plot, qu'un cordon ou tout autre type d'élément permettant le collage, après fluage, des deux structures.

L'invention a également pour objet un procédé d'assemblage de deux structures, comportant :
- la formation d'au moins un plot espaceur dans une première des deux structures, ce(s) plot(s) espaceur(s) définissant, sur ses bords, un, ou des, caisson(s) latéral (latéraux), chaque caisson latéral présentant un fond,
- la formation, sur la deuxième structure, d'au moins un joint en un matériau fluable et mouillable sur les deux structures,
- le positionnement des deux structures de manière à ce que chaque joint de la deuxième structure soit introduit dans un caisson de la première structure,
- l'assemblage des deux structures par chauffage des joints, pour les faire fluer, et la réalisation d'un contact intime des deux structures.

Selon ces deux autres procédés, le matériau formant le(s) joint(s) fluable(s) peut fluer dans le, ou les, caisson(s), et les deux structures sont rapprochées jusqu'à obtenir un contact intime, par exemple par adhérence moléculaire, en dehors des caissons ; la tenue mécanique de l'assemblage est assurée essentiellement par le matériau fluable, au niveau des caissons et le parallélisme est assuré par ledit contact intime.

Si l'on ne réalise pas de plots espaceurs (et les caissons correspondants), on répartit de préférence les plots de matériau fluable de manière à ce que, lors du fluage, on obtienne un film de matériau d'épaisseur homogène, la plus faible possible. Ainsi, les caractéristiques des plots sont de préférence déterminées de façon à obtenir un film d'épaisseur minimum, et constant.

Le matériau fluable et mouillable peut être une résine photosensible, ou un matériau fusible du type Sol-Gel de silice (SOG) ou un alliage métallique In ou Pb-Sn, ou encore une résine négative. Cette dernière présente un meilleur pouvoir adhésif après réticulation du polymère.

Quel que soit le mode de réalisation envisagé, deux structures, assemblées selon l'invention, peuvent ensuite être découpées. L'étape de découpe ne perturbe pas le contact intime, du fait de la résistance mécanique introduite par les éléments en matériau fluable.

L'invention a également pour objet un assemblage d'une première et d'une seconde structure ayant chacune au moins une face plane, ces deux faces planes étant en contact intime, un joint continu en un matériau fluable et mouillable étant situé à l'interface entre les deux faces planes.

L'invention a également pour objet l'assemblage d'une première et d'une seconde structure ayant chacune au moins une face plane, au moins l'une d'elle comportant en outre au moins un caisson latéral présentant un fond en retrait par rapport à la face plane, les deux faces planes étant en contact intime, un joint de collage en un matériau fluable et mouillable étant disposé dans au moins un caisson latéral, et reliant les deux structures.

Ces assemblages résolvent les mêmes problèmes, et présentent les mêmes avantages, que ceux décrits ci-dessus en liaison avec l'exposé des procédés : le parallélisme des deux structures, au niveau des faces en contact, est assuré par contact intime, et une bonne tenue mécanique est garantie par l'utilisation du joint de collage en un matériau fluable et mouillable.

Les première et seconde structures peuvent être respectivement un milieu actif solide pour cavité microlaser et un absorbant saturable pour cavité microlaser.

De même, les première et seconde structures peuvent être respectivement un milieu actif solide pour cavité microlaser et un élément en un matériau optiquement non-linéaire (par exemple doubleur ou tripleur de fréquence, ou oscillateur paramétrique optique).

Selon un autre mode de réalisation, les première et seconde structures peuvent être respectivement un milieu actif solide pour cavité microlaser et un composant microoptique tel qu'un microprisme, un micromiroir, ..., ou encore ces deux structures peuvent être respectivement deux composants de microoptique quelconques.

L'invention a également pour objet un assemblage pour cavité microlaser, comportant un milieu actif solide, un miroir intermédiaire plan disposé sur une face plane du milieu actif laser, un élément en un matériau dont l'indice optique est apte à être modulé par une perturbation extérieure, cet élément présentant une face plane, cette dernière étant en contact avec le miroir par contact intime, un joint en un matériau fluable et mouillable étant situé à l'interface formée par les deux faces planes.

L'invention a également pour objet un assemblage pour cavité microlaser comportant un milieu actif solide, un miroir intermédiaire plan disposé sur une face plane du milieu actif laser, un élément en un matériau dont l'indice optique est apte à être modulé par une perturbation extérieure, cet élément présentant une face plane, le miroir et éventuellement le milieu actif et/ou l'élément à indice modulable présentant au moins un caisson latéral, avec un fond en retrait par rapport à la face plane correspondante, la face plane de l'élément à indice modulable étant en contact avec le miroir intermédiaire plan par contact intime, un joint de collage en un matériau fluable et mouillable étant disposé dans au moins un caisson latéral, et reliant d'une part l'élément à indice modulable et d'autre part le milieu actif solide.

Ainsi, on réalise ainsi un assemblage pour une cavité microlaser déclenchée de manière active.

L'invention a également pour objet un dispositif pour émetteur de lumière infrarouge comportant un assemblage tel que décrit ci-dessus, les première et deuxième structures étant respectivement :
- un élément semi-conducteur, apte à émettre un rayonnement infrarouge,
- une cavité microlaser incorporant des moyens de déclenchement, disposée de manière à pouvoir pomper optiquement l'élément semi-conducteur.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- les figures 1A à 1E représentent des étapes d'un procédé selon un premier mode de réalisation de l'invention,
- les figures 2A à 2G représentent des étapes d'un procédé selon un second mode de réalisation de l'invention,
- les figures 3A et 3B représentent des vues de côté et de dessus d'un dispositif obtenu par un procédé selon le second mode de réalisation,
- les figures 4A à 4E représentent des étapes d'une variante du procédé selon le second mode de réalisation de l'invention,
- la figure 5 représente un composant obtenu par une variante du second mode de réalisation de l'invention,
- les figures 6A et 6B et 7A à 7C représentent d'autres variantes du second mode de réalisation de l'invention,
- la figure 8 représente un composant obtenu pour une variante d'un procédé selon l'invention,
- les figures 9A et 9B illustrent la structure d'un microlaser à déclenchement actif, obtenu selon un procédé conforme à l'invention,
- les figures 10A à 10F et 11A à 11E représentent des étapes de réalisation d'un microlaser à déclenchement actif, selon un procédé conforme à l'invention,
- les figures 12 à 15 représentent des structures de microlasers selon l'invention.

### Exposé détaillé de modes de réalisation de l'invention

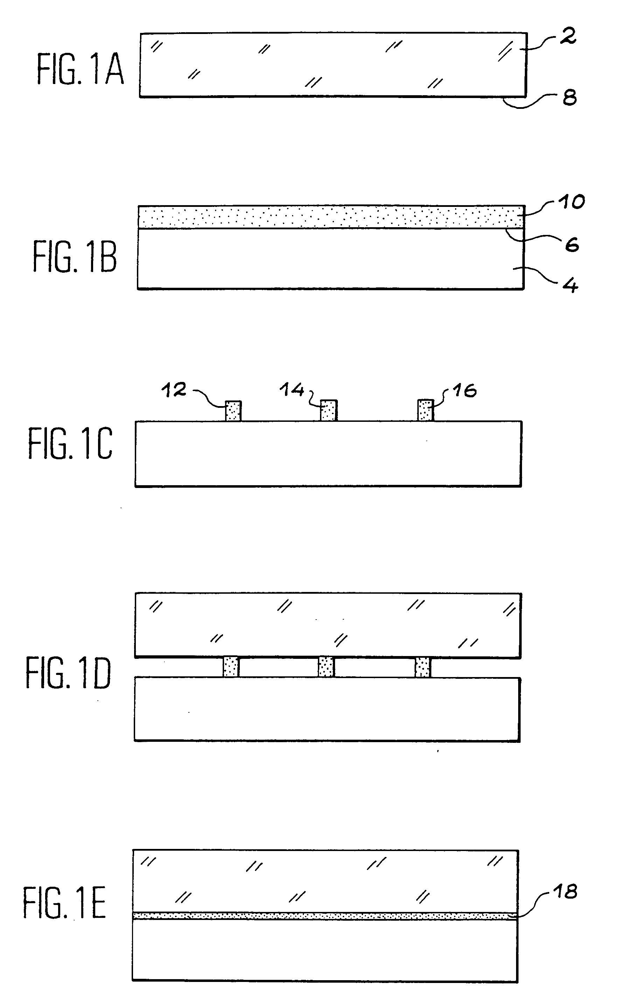

Des étapes d'un premier procédé selon l'invention sont illustrées sur les figures 1A à 1E. Sur ces figures, les références 2 et 4 désignent deux structures que l'on cherche à assembler. Ces structures sont par exemple une lame 4 d'un matériau actif laser et une lame 2 d'un matériau absorbant saturable. Des exemples de matériaux pour ces deux éléments sont donnés dans le document EP-653 824 (US-5 495 494) ; on trouvera également dans ces documents des critères pour sélectionner lesdits matériaux.

Selon un autre exemple, la structure 4 peut être une lame d'un matériau absorbant saturable, tandis que la structure 2 est une lame d'un matériau optiquement non-linéaire, permettant de multiplier la fréquence de base d'une cavité microlaser par un nombre entier n (n>2).

Chacune de ces structures présente une face plane 6, 8. Sur l'une d'elles, une couche de résine photosensible est déposée (figure 1B).

Par gravure de la couche 10 (par photolithographie par masquage), des plots 12, 14, 16 sont réalisés. La répartition des plots est de préférence uniforme, de manière à ce que, au cours de l'étape ultérieure d'écrasement, ils se répartissent en une couche homogène en épaisseur.

Les deux structures, ou lames, 2, 4 sont ensuite amenées face à face (figure 1D). Par chauffage sous pression des plots de résine 12, 14, 16, les deux structures sont amenées en contact intime l'une de l'autre et se "collent" sous l'effet de l'adhérence de la résine polymérisée (figure 1E).

Il reste une couche 18 d'interface de collage, d'une épaisseur de l'ordre de quelques dixièmes de micromètres, par exemple 0,1 µm. Cette couche 18 assure la stabilité mécanique des deux structures l'une par rapport à l'autre, notamment au cours d'une étape ultérieure de découpage, par exemple à la scie diamantée dans le cas d'éléments pour une cavité microlaser. Le parallélisme des deux surfaces en contact l'une avec l'autre est assuré par la faible épaisseur de la résine. Afin d'améliorer encore le contrôle du parallélisme, on contrôle l'épaisseur et la répartition des plots de matériau fluable 12, 14, 16. De plus, il est possible de contrôler l'indice de réfraction de la couche 18, par dopage (dans le cas d'un Sol-Gel de silice, par dopage avec des oxynitrures SiOₓN_{y}) : ainsi, on adapte au mieux le saut d'indices à l'interface des matériaux 2, 4 en présence, et on peut réduire d'autant les pertes optiques.

Cette possibilité de mieux contrôler le parallélisme ainsi que l'indice de la couche intermédiaire font de celle-ci un élément beaucoup plus avantageux que les simples colles "optiques" utilisées habituellement. En outre, par rapport à une colle, la seule diffusion possible, à partir de chaque plot 12, 14, 16 entre les deux surfaces, est très locale. Enfin, l'épaisseur obtenue est plus faible que l'épaisseur obtenue avec une colle, et de l'ordre de plusieurs micromètres.

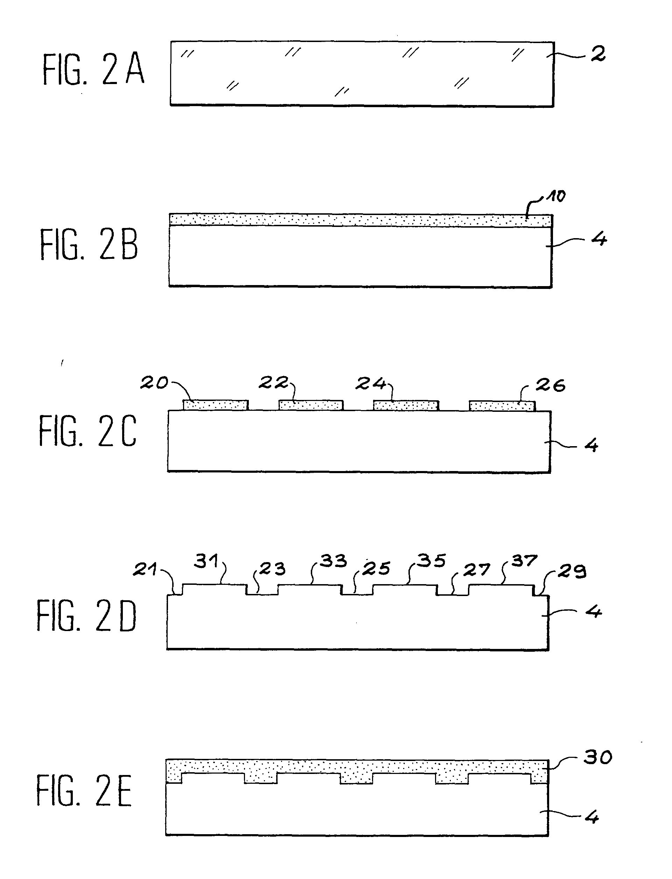

Un autre mode de réalisation d'un procédé conforme à l'invention est illustré sur la figure 2A à 2G. Les figures 2A et 2B représentent encore deux structures 2, 4 à assembler, pouvant être du même type que celles décrites ci-dessus en liaison avec les figures 1A et 1B.

Ce second procédé permet de réaliser des plots espaceurs sur l'une ou l'autre des surfaces des structures à mettre en contact, définissant ainsi des caissons latéraux dans lesquels des joints, ou plots sont introduits en matériau fluable et mouillable, permettant d'assurer la cohésion mécanique de l'ensemble lors d'une découpe ultérieure.

Le procédé comprend ensuite deux niveaux de masquage. Le premier niveau permet de matérialiser, après gravure d'un des substrats, les plots espaceurs et les caissons, enterrés par rapport à l'interface de collage. Le second niveau de technologie permet de réaliser, autour de chaque plot espaceur (ou autour de chaque puce, dans le cas de microéléments, par exemple pour des microlasers) les cordons, ou les plots, de matériau fluable et mouillable, qui seront en position enterrée après avoir réalisé le contact intime des deux structures.

Ainsi, une couche 10 de résine photosensible est préalablement déposée sur la surface d'une des structures (figure 2B). Cette couche est gravée (par photolithographie par masquage) de manière à définir des plots espaceurs 20, 22, 24, 26 (figure 2C).

Le substrat 4, sur lequel les plots espaceurs ont été réalisés, est ensuite gravé afin de définir des plots espaceurs 31, 33, 35, 37 bordés par des caissons latéraux 21, 23, 25, 27, 29. Ces derniers ont une profondeur (distance entre le fond de chaque caisson et la surface supérieure des plots espaceurs voisins) de l'ordre du µm. Dans le cas où le substrat 4 est un substrat de matériau actif laser, la gravure peut être réalisée par usinage ionique ou gravure chimique. Dans le cas de substrat en silice massive (cas d'un substrat pour support de microlentilles) on peut également utiliser une technique de gravure ionique réactive (RIE).

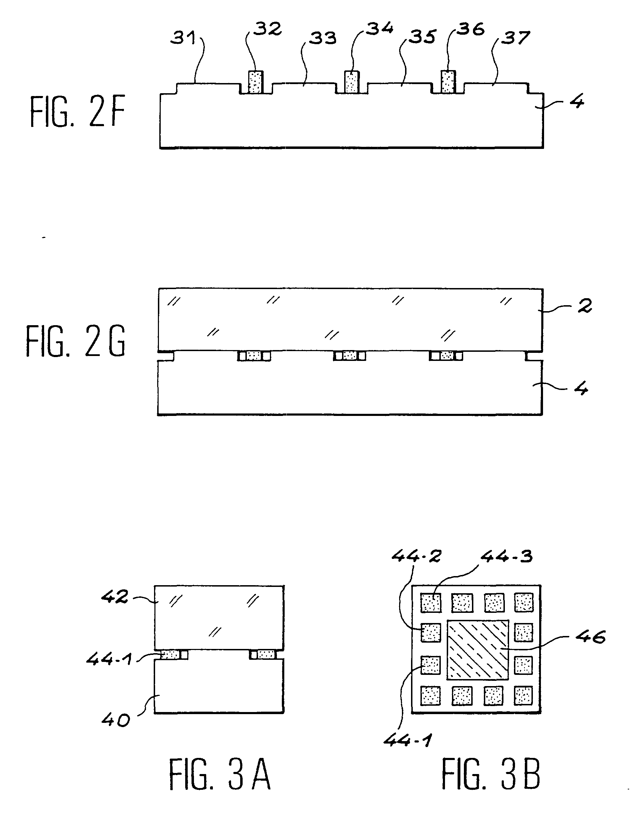

Sur la structure gravée ainsi obtenue, après élimination des plots 20 à 26 en résine, on réalise (figure 2E) l'étalement d'une couche 30 de matériau fluable et mouillable. Cette couche est gravée (figure 2F) de manière à former des plots de connexion 32, 34, 36, à l'intérieur des caissons 23, 25, 27 gravés dans le substrat 4. Dans le cas où le matériau fluable et mouillable est une résine photosensible, cette gravure peut être réalisée par photolithographie par masquage. Après alignement, l'assemblage (Figure 2G) des substrat 2 et 4 s'effectue par exemple par pression à chaud (T∼200°C). Un contact intime est établi entre la surface 8 de la structure 2 et la surface supérieure des plots espaceurs 31, 33, 35, 37. Les plots espaceurs servent en fait de butées mécaniques. Les cordons, ou plots 32, 34, 36 de matériau fluable et mouillable peuvent fluer à l'intérieur des caissons gravés, sur les bords des plots espaceurs. L'avantage de ce procédé, par rapport au premier procédé exposé dans le cadre de la présente invention, est que les paramètres de "collage" n'influent pas sur le contrôle du. parallélisme obtenu : il n'y a pas de couche intermédiaire entre les deux structures 2, 4 après assemblage.

Dans le cas où le matériau fluable et mouillable est une résine photosensible, le maintien mécanique des deux substrats 2, 4 est assuré dès que la réticulation de la résine a eu lieu.

La hauteur des cordons ou des plots 32, 34, 36 est de préférence supérieure, par exemple de quelques micromètres, à la profondeur des caissons 23, 25, 27.

Après assemblage des deux structures 2,4, il est possible de réaliser une découpe de composant individuel. Un tel composant est représenté en vue de côté et de dessus, respectivement sur les figures 3A et 3B. Deux composants élémentaires 40, 42 présentent une surface 46 de contact. Des plots de résine 44-1, 44-2, 44-3, ... assurent le maintien mécanique de l'ensemble au cours de la découpe et ultérieurement.

Sur les figures 2F, 2G, 3A, 3B le matériau fluable et mouillable est représenté sous la forme de plots discontinus. Il est également possible de réaliser des cordons continus de matériau fluable et mouillable. Cependant, la réalisation de plots discontinus permet, d'une part de favoriser l'écrasement du matériau fluable lors du collage, sans déborder des caissons, et d'autre part de favoriser un éventuel dégazage qui pourrait gêner le contact intime (par exemple un dégazage de solvant, si le matériau fluable est une résine, lors du chauffage de réticulation de celle-ci).

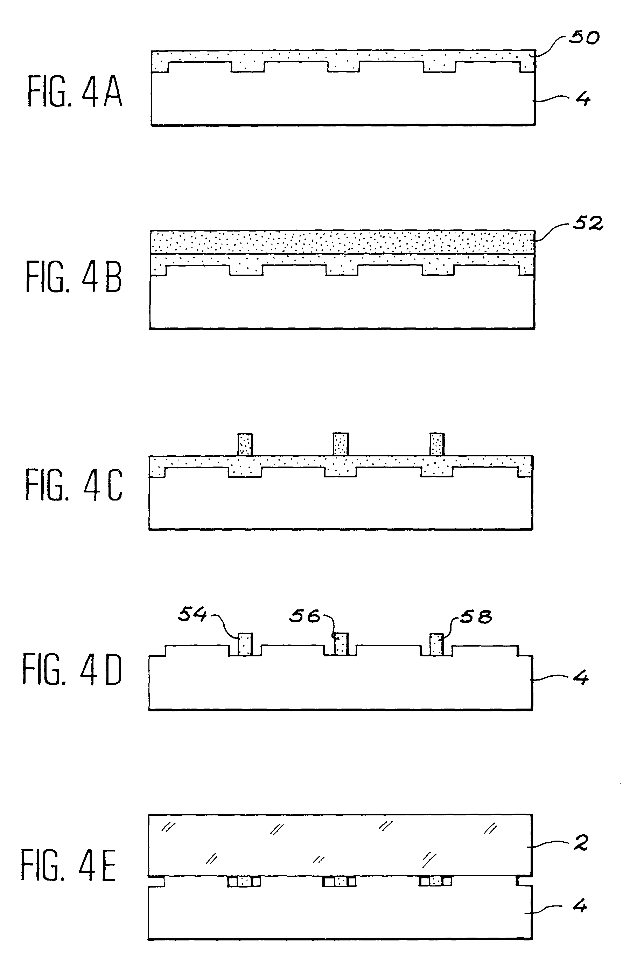

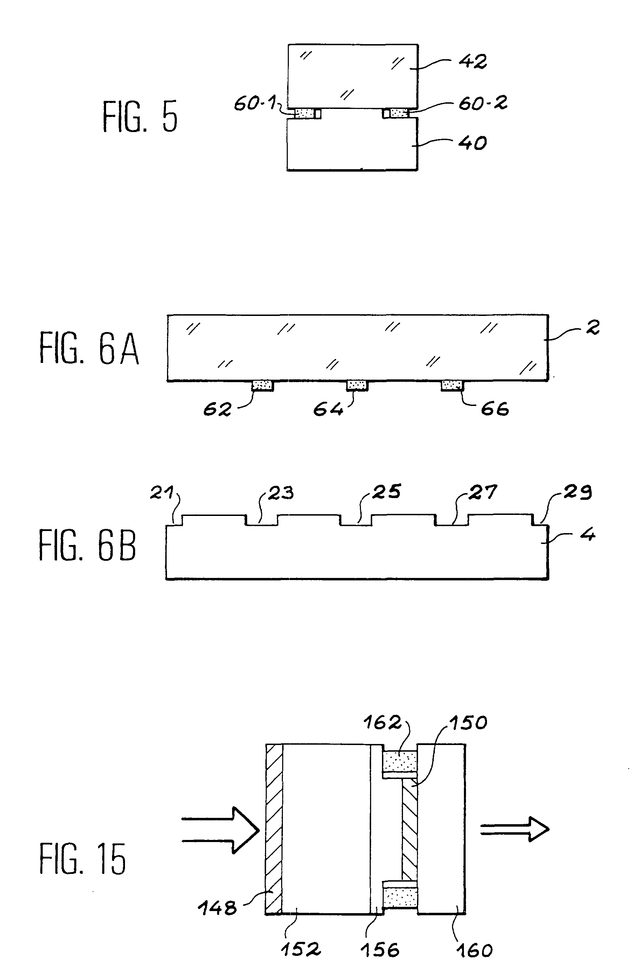

Dans le cas où le matériau fluable utilisé n'est pas une résine (c'est par exemple de la silice Sol-Gel ou un autre matériau fusible : In, Pb-Sn), on procède de la manière décrite ci-dessus en liaison avec la figure 2A à 2D. Puis (figure 4A) une couche 50 de matériau fluable et mouillable est réalisé sur le substrat 4. Par dessus cette couche, une couche 52 de résine photosensible est étalée (figure 4B). La géométrie des joints (cordons ou plots) est définie dans cette couche 52, par photolithographie par masquage (figure 4C). On peut ensuite graver des cordons, ou des plots, 54, 56, 58 en matériau fusible, dans les caissons 23, 25, 27 gravés dans le substrat 4 (figure 4D). L'alignement et l'assemblage des substrats 2, 4 peut ensuite avoir lieu, par exemple par chauffage sous pression (figure 4E). Le contact intime est réalisé à l'interface du substrat 2 et des plots espaceurs 31, 33, 35, 37, le maintien mécanique lors d'une découpe ultérieure étant assurée par les plots ou le cordon en matériau fluable et mouillable. Une découpe conduit à un composant comportant deux structures élémentaires 40, 42, en contact intime, l'ensemble des deux structures étant maintenu par les plots 60-1, 60-2 en matériau fluable et mouillable (figure 5).

Le procédé avec formation de plots espaceurs et gravure de caissons a été exposé ci-dessus en version "simple face". Une version "double face" peut également être réalisée.

Ainsi, sur les figures 6A et 6B, les caissons 21, 23, 25, 27, 29 sont gravés dans le substrat 4, tandis que les joints (cordons ou plots) de matériau fluable et mouillable 62, 64, 66 (en résine ou en un autre matériau) sont formés, par des techniques identiques ou équivalentes à celles exposées ci-dessus, sur l'autre structure 2. L'alignement et l'assemblage ont ensuite lieu de la même manière que décrite ci-dessus.

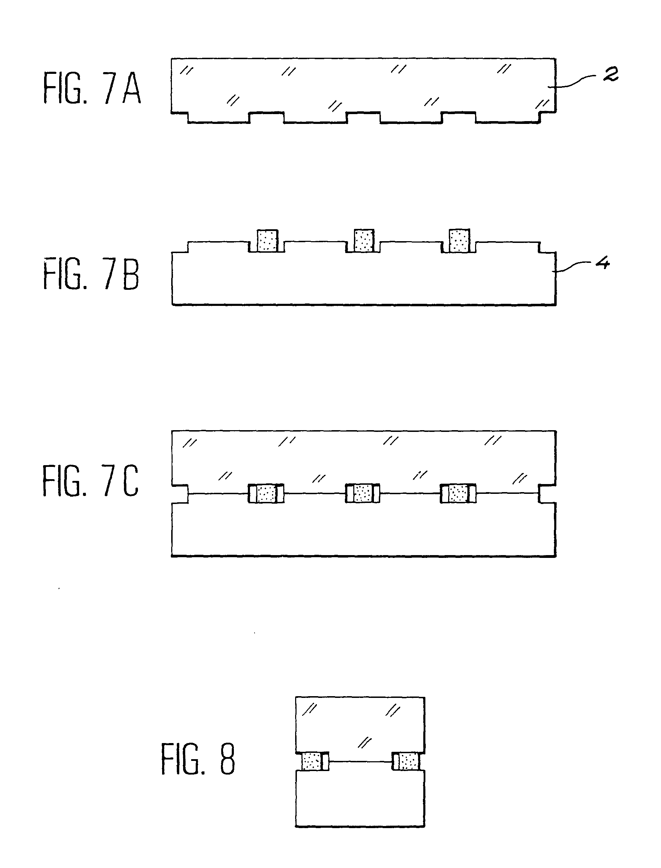

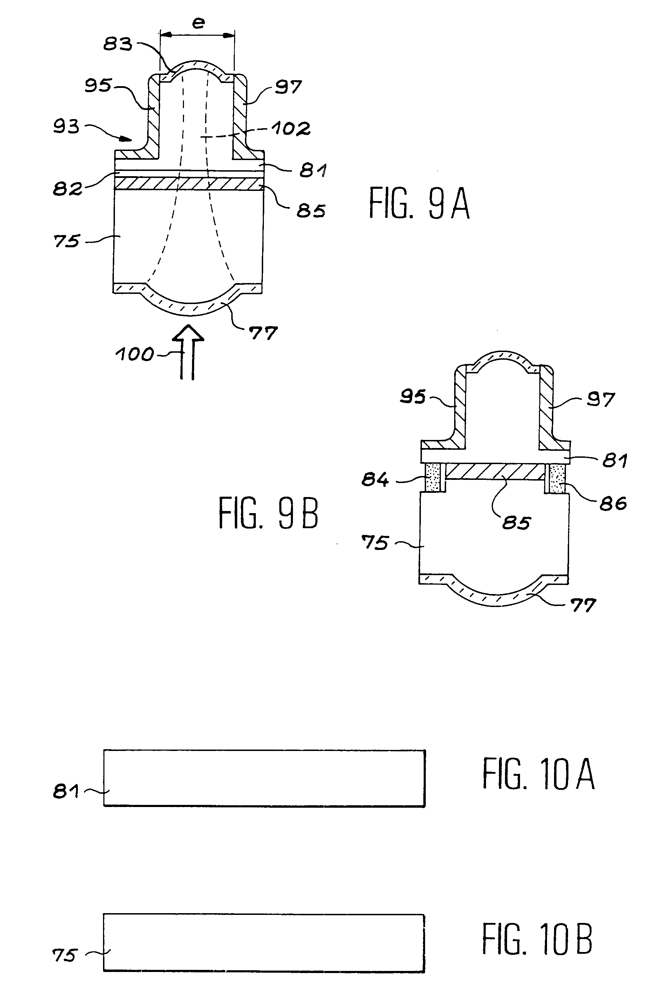

Comme illustré sur les figures 7A et 7B, il est également possible de graver des caissons dans les deux substrats 2, 4, des plots, ou cordons, de matériau fluable et mouillable étant ensuite formés sur l'un et/ou l'autre des deux substrats. L'alignement et l'assemblage des deux composants sont réalisés de la manière déjà décrite ci-dessus : le contact intime a lieu à la surface des plots espaceurs définis sur chacune des structures 2, 4 (figure 7C). Un composant individuel obtenu après découpage est illustré sur la figure 8.

L'un ou l'autre des procédés selon l'invention, décrit ci-dessus, peut être appliqué à la réalisation d'assemblage hybride de composants microlasers et d'éléments microoptiques. Un exemple va être donné de réalisation d'un microlaser à déclenchement actif par tension de commande externe.

Une puce microlaser à déclenchement actif présente une structure représentée schématiquement sur la figure 9A. La référence 75 désigne un milieu actif laser, tel que par exemple un milieu YAG dopé au néodyme (Nd). Ce milieu est compris entre un miroir d'entrée 77 et un miroir intermédiaire 85 avec lesquels il constitue une première cavité résonnante. Une seconde cavité résonnante est constituée par le miroir intermédiaire 85, un miroir de sortie 83 et un matériau 81, possédant un indice de réfraction susceptible de varier en fonction d'une perturbation extérieure. Ce peut être par exemple un matériau électrooptique, tel que du LiTaO₃ auquel on applique une différence de potentiel à l'aide de deux électrodes de contact 95, 97. En fonctionnement, une telle structure microlaser est pompée à l'aide d'un faisceau de pompage 100 obtenu par exemple à l'aide d'une diode laser III-V qui est soit directement hybridée sur le microlaser, soit couplée à ce dernier par une fibre optique. Dans le cas où le matériau 75 est du YAG dopé au néodyme, un faisceau 100 de pompage à 800 nm convient.

Sur la figure 9A, le micromiroir 77 d'entrée de la cavité microlaser présente un rayon de courbure, qui permet de réduire la taille du faisceau laser à l'intérieur du matériau 81. De préférence, ce rayon de courbure est supérieur à la longueur totale du microlaser (longueur L₁ du milieu actif 75 + longueur L₂ du milieu 81). Typiquement, le rayon de courbure est donc supérieur à environ 1,5 mm. Avec une telle condition, la cavité est stable optiquement. On obtient ainsi un diamètre Φ du faisceau laser 102, à l'intérieur du milieu 81, qui est petit, typiquement de quelques dizaines de micromètres. Dans ces conditions, l'épaisseur e du milieu 81, nécessaire au déclenchement actif de la cavité, est typiquement comprise entre 100 µm et 500 µm. Cette épaisseur se compare très favorablement aux épaisseurs mises en oeuvre dans l'art antérieur : ainsi, le dispositif décrit dans l'article de J.J. Zayhowski, Optics letters, vol. 17, n°17, p. 1201-1203, 1992, nécessite un élément électrooptique d'épaisseur 1 mm. Or, une telle épaisseur (1 mm) nécessite, pour le bon fonctionnement du déclenchement, l'application d'une tension de l'ordre de 1000 volts entre les deux électrodes ; une épaisseur d'environ 100 µm permet de limiter la tension nécessaire à une valeur comprise entre 50 et 100 volts.

La structure de la figure 9A présente également un micromiroir concave 83 en sortie du microlaser. Dans ce cas, les rayons de courbure R₁ et R₂ de chacun des micromiroirs 77, 83 sont choisis de façon à obtenir deux cavités stables optiquement. Dans le cas de deux cavités couplées (cas de la figure 9A), on prend R₁>L₁ et R₂>L₂ pour satisfaire à cette condition. Le cas d'une cavité plan-concave (le miroir de sortie est un miroir plan) correspond à R₂=∞.

L'invention s'appliquerait de la même manière à la réalisation d'une structure plan-plan, la seule différence étant une épaisseur e plus importante de matériau électrooptique 81.

Le microlaser de la figure 9A comporte deux structures : la première constituée par le milieu actif laser 75 et les miroirs 77, 85 ; la seconde constituée par le matériau électrooptique 81, son miroir de sortie 83 et ses électrodes 95, 97. Ces deux structures sont assemblées par le premier mode de réalisation du procédé selon la présente invention, et la référence 82 désigne un joint obtenu après écrasement de plots de matériau fluable et mouillable, le matériau électrooptique 81 et le miroir 85 étant en contact intime.

La figure 9B représente une variante de la structure ci-dessus, dans laquelle le miroir 85 et le matériau électro-optique 81 sont en contact intime, mais sans joint intermédiaire : des plots 84, 86 de matériau fluable et mouillable sont formés dans des caissons latéraux, le milieu actif laser 75 et le miroir 85 ayant été préalablement gravés pour réaliser lesdits caissons. Cette structure correspond à un microlaser déclenché activement, obtenu à l'aide du second mode de réalisation du procédé selon l'invention.

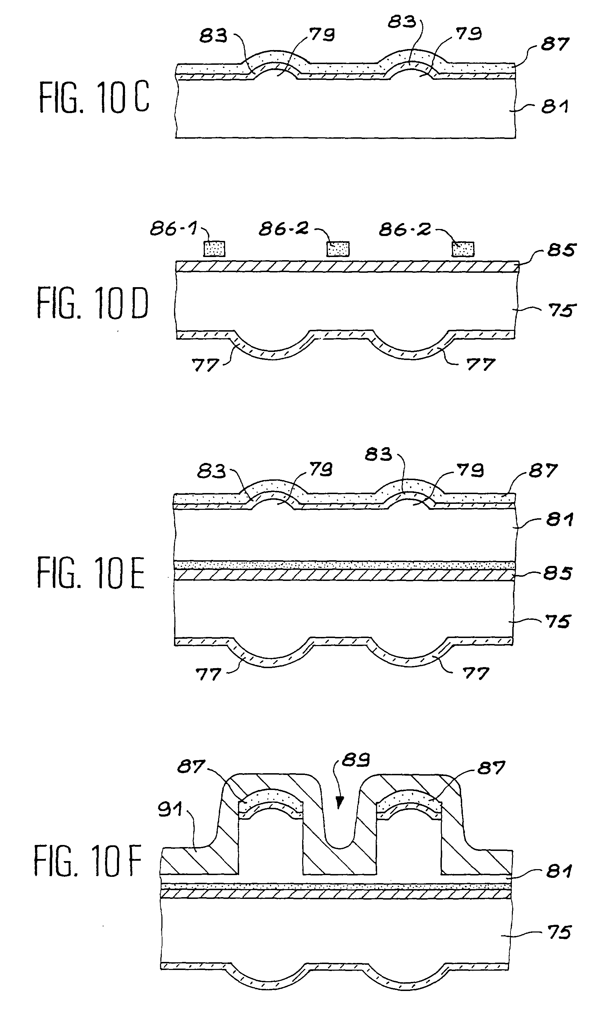

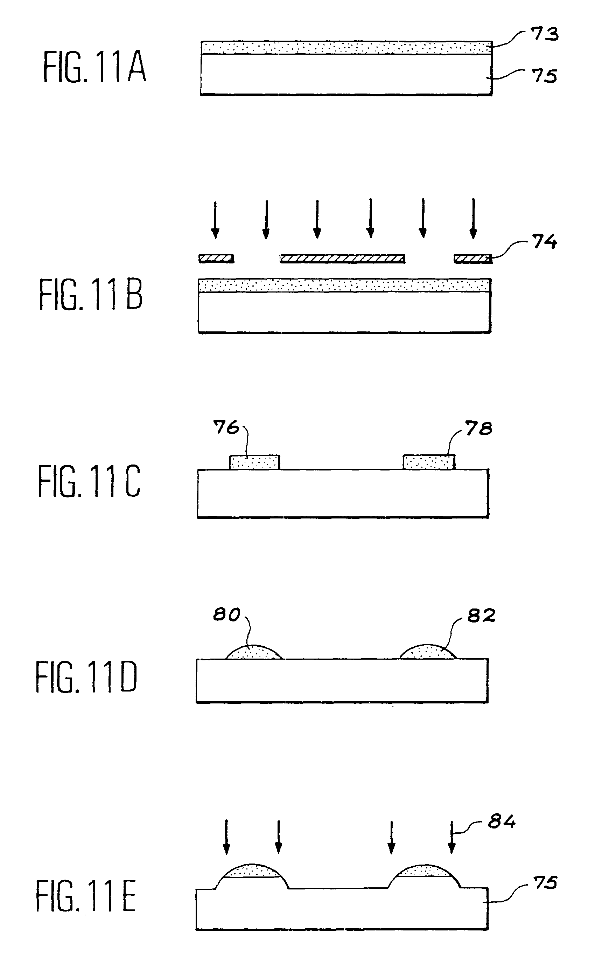

Des étapes du procédé pour obtenir la structure de la figure 9A vont être brièvement résumées ci-dessous, en liaison avec les figures 10A à 10F et 11A à 11E.
1°) - Dans une première étape, on procède au calcul des rayons de courbure R₁ et R₂, si la stabilité d'une ou des cavités est souhaitée.
2°) - Dans une deuxième étape (figures 10A, 10B), on procède au découpage et au polissage double face d'une lame 75 de matériau laser et d'une lame 81 du matériau d'indice variable, tel qu'un matériau électro-optique (par exemple LiTaO₃),
3°) - On fabrique ensuite par photolithographie et usinage, un micromiroir sur la face d'entrée du matériau laser (diamètre typique 100 à 500µm, et rayon de courbure R₁ de 1 à 2 mm). Cette étape est illustrée sur les figures 11A à 11E. Dans une première sous-étape (figure 11A), il est procédé au dépôt d'une couche 73 de résine photosensible sur la face d'entrée du matériau laser 75. Puis il est procédé à l'insolation de la résine à travers un masque 74 à l'aide d'un rayonnement UV (figure 11B). L'étape suivante (figure 11C) est une étape de révélation chimique de la résine, ne laissant subsister que des plots 76, 78 destinés à former les micromiroirs. Il est ensuite procédé au fluage thermique de la résine (figure 11D) pour former les micromiroirs 80, 82 en résine, et à l'usinage par transfert de forme du matériau laser 75 à l'aide d'un faisceau d'ions 74 (figure 11E) jusqu'à élimination de la résine.
   Les étapes 4°) à 9°) sont ensuite décrites en liaison avec la figure 10C.
4°) - Il est procédé au dépôt du miroir d'entrée 77 sur la face d'entrée du matériau laser 75 (par exemple, pour le miroir d'entrée dichroïque, avec une réflectivité supérieure à 99,5% à la longueur d'onde du faisceau laser, et une transmission supérieure à 80% à la longueur d'onde du faisceau de pompage).
5°) - Puis il est procédé à la fabrication, par photolithographie et usinage, de microbossages 79 comme décrit précédemment sur la surface de sortie du matériau électro-optique 71 (diamètre typique 100 à 500 µm et rayon de courbure R₂ de 1 à 2 mm). Dans le cas où le miroir de sortie est un miroir plan, il n'est pas procédé à la formation de microbossages sur la face de sortie du matériau électro-optique. Par ailleurs, le diamètre du miroir (microlentille) de sortie peut être inférieur au diamètre du micromiroir d'entrée.
6°) - On procède ensuite au dépôt du micromiroir de sortie 83 sur la face de sortie du matériau électro-optique 81 (miroir de sortie avec une réflectivité typique de 85 à 99% à la longueur d'onde du faisceau laser et éventuellement avec une réflectivité supérieure à la longueur d'onde du faisceau de pompage pour réfléchir le faisceau de pompe qui n'est pas totalement absorbé au premier passage).
7°) - Dans la septième étape, un miroir intermédiaire 85 est déposé à l'interface matériau laser 75-matériau électro-optique 81.
8°) - La lame 81 et le miroir 85 sont ensuite mis en contact intime (figure 10E), avec maintien mécanique par joint 82 de matériau fluable et mouillable ; ce dernier est obtenu, conformément à l'invention, à partir de plots 86-1, 86-2, 86-3, ... préalablement formés sur la surface par exemple du miroir 85.
9°) - Il est possible de protéger la face de sortie par un dépôt de résine 87 (figure 10C).
10°) - Il est possible de réaliser des rainures 89 (figure 10F) dans le matériau électro-optique à l'aide d'une scie à lame diamantée utilisée en microélectronique, pour pouvoir réaliser par la suite les électrodes avec l'espacement e voulu (de l'ordre de 100 µm, par rapport à une distance interélectrode de 1mm dans l'art antérieur).
11°) - Il est ensuite procédé au dépôt de contacts électriques par évaporation (par exemple, dépôt d'une couche Cr-Au 91 qui enrobe la résine 87 et le matériau électrooptique 81).
12°) - Des puces élémentaires 93, de taille sensiblement égale à 1mm², sont ensuite découpées. On obtient la structure illustrée sur la figure 9A, après décapage chimique de la résine de protection et lift off de la couche 91.
13°) - Les puces sont montées sur un support de circuit imprimé métallisé et adapté en impédance, avec prise de contact électrique et montage dans un boîtier blindé.
14°) - Il peut ensuite être procédé au montage en boîtier et à la connexion avec une diode laser de pompe et un connecteur électrique pour le déclenchement.

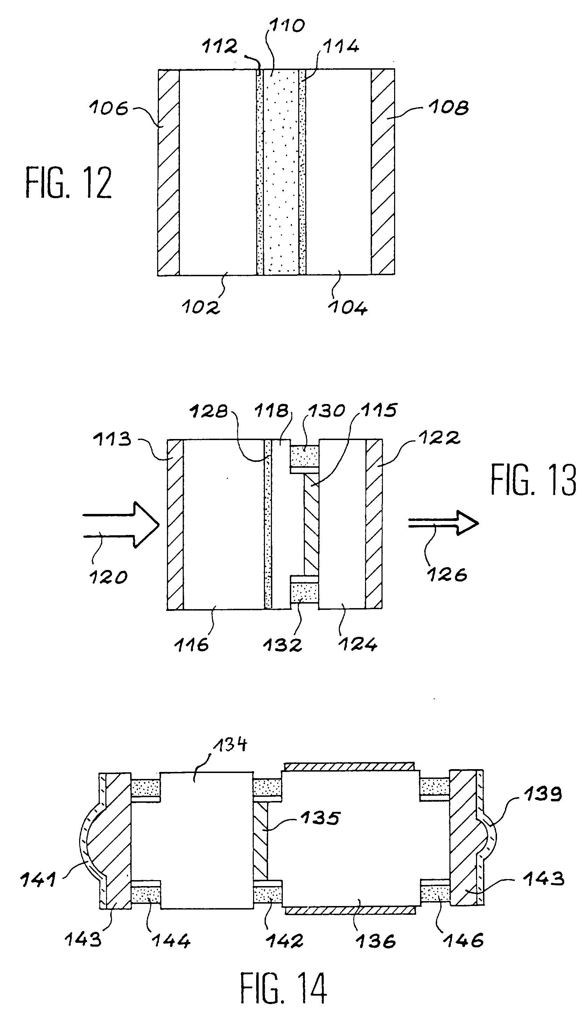

L'invention peut être par ailleurs appliquée à toute autre structure de cavité microlaser. Par exemple, la figure 12 représente une cavité microlaser comportant un milieu actif laser 102, un miroir d'entrée 106, un miroir de sortie 108. A l'intérieur de la cavité se trouve en outre deux autres éléments :
- un élément 110 de déclenchement de la cavité, en mode actif ou passif,
- un élément 104, en un matériau non-linéaire permettant de multiplier par un facteur n (n≥2) la fréquence de base du milieu actif laser 102.

Comme on le voit sur la figure 12, deux joints 112, 114 de matériau fluable et mouillable sont disposés respectivement à l'interface d'une part du milieu actif laser 102 et de l'élément de déclenchement 110, et d'autre part de l'élément de déclenchement 110 et du milieu non-linéaire 104. La présence simultanée, à l'intérieur de la cavité, de moyens de déclenchement et de l'élément non-linéaire 104 a pour conséquence une augmentation très important du rendement de fonctionnement du milieu non-linéaire 104.

Selon une variante, non représentée sur les figures, des caissons peuvent être gravés dans le milieu actif laser et dans l'élément de déclenchement 110, afin de réaliser une structure incorporant des caissons latéraux dans lesquels seront disposés les joints de matériau fluable et mouillable ; l'interface des éléments 102, 110 et 110, 104 est alors assurée par contact intime, sans joint transversal, ce qui permet de réaliser une cavité microlaser déclenchée, avec multiplication de fréquences, fonctionnant à un rendement optimal : le faisceau de pompage et le faisceau laser ne rencontrent plus aucun joint sur leur trajet dans la cavité.

La figure 12 représente une cavité plan-plan. Il est également possible de réaliser une cavité stable avec des micromiroirs concaves en entrée et/ou en sortie de cavité. Une cavité stable présente alors un seuil de déclenchement plus faible, ainsi qu'un meilleur rendement. En outre, la présence d'un micromiroir concave permet d'ajuster la taille du faisceau laser dans les différents milieux, à l'intérieur de la cavité, ce qui permet d'accroître encore la densité de puissance au niveau de l'élément absorbant saturable 110 et du cristal multiplicateur 104. La réalisation de cette structure fait intervenir des étapes de préparation des plaques de matériau laser, de matériau de déclenchement, et de matériau non-linéaire que l'on superpose et que l'on réunit selon l'un des procédés décrits dans la présente demande.

Une autre structure pouvant être obtenue par un procédé selon l'invention est illustrée sur la figure 13. Les références 113 et 115 désignent des miroirs d'entrée et de sortie d'une cavité microlaser qui comporte un milieu actif laser 116 et des moyens 118 de déclenchement, en mode actif ou passif, de cette cavité. La référence 120 désigne un faisceau de pompage de la cavité. Celle-ci émet un faisceau laser qui va pomper à son tour une structure d'oscillateurs paramétriques optiques (OPO), comportant essentiellement deux miroirs 115, 122 entre lesquels est placé un matériau non-linéaire 124. Cette cavité émet à son tour un faisceau OPO 126.

Le matériau constitutif du milieu 124 peut être choisi parmi les matériaux connus, non linéaires, tels que par exemple KTiOPO₄ (KTP), MgO:LiNbO₃, β-BaB₂O₄, LiB₃O₅, et AgGaSe. Les propriétés du matériau KTP sont décrites, par exemple, dans l'article de Terry et al. paru dans Journal of Optical Society of America, B, vol. 11, pages 758-769 (1994). Les propriétés d'autres matériaux non linéaires permettant de réaliser un OPO sont décrite dans l'ouvrage de R.W. Boyd intitulé "Non-linear optics" (Academic Press, 1992, USA, N°ISBN 0-12-121680-2), en particulier pages 85 et suivantes.

Du fait du pompage par un microlaser, il est possible non seulement d'abaisser l'énergie de seuil de la cavité OPO, mais également de réduire la longueur du cristal 124 nécessaire au fonctionnement de l'OPO : ainsi, dans l'article de Terry et al. mentionné ci-dessus, un OPO avec un cristal de 20mm de longueur est décrit, tandis que l'invention permet d'utiliser des matériaux de quelques mm d'épaisseur, par exemple 5 mm. D'une façon générale, du fait des propriétés du faisceau émis par le laser, ce résultat (énergie de seuil abaissée, longueur de cristal réduite) s'applique non seulement au cristal de KTP décrit dans l'article de Terry et al. mais aussi à tout autre cristal ou matériau non linéaire utilisé pour réaliser une cavité OPO.

La structure illustrée sur la figure 13 est extrêmement compacte. La cavité microlaser étant elle-même très compacte (même avec un élément de déclenchement 118), il est donc possible d'obtenir un oscillateur OPO dont la longueur totale, y compris ses moyens de pompage, ne dépasse pas 6mm, pour une section de 1mm², soit un volume total de 6mm³.

Le dispositif illustré sur la figure 13 comporte en outre un joint 128 en un matériau fluable et mouillable, qui assure la liaison par contact intime entre le milieu actif laser 116 et le milieu de déclenchement 118. Le contact entre les miroirs 115 et l'élément 124 est également assuré par contact intime, mais les joints, ou plots, 130, 132 de matériau fluable et mouillable sont situés dans des caissons latéraux, gravés dans l'élément de déclenchement 118 et dans le miroir 115. Il sera également possible de réaliser une variante, non représentée sur les figures, dans laquelle la liaison entre le milieu actif 116 et l'élément de déclenchement 118 serait assurée par contact intime sans joint 128 transversal, les joints de matériau fluable et mouillable étant disposés dans des caissons latéraux gravés par exemple dans le milieu actif laser 116. Dans ce cas, le faisceau de pompage et le faisceau laser ne rencontrent, à l'intérieur du dispositif, plus aucun joint : l'oscillateur paramétrique optique fonctionne alors avec un rendement optimal. Là encore, les procédés utilisés sont ceux qui ont été décrits ci-dessus.

Une autre structure de cavité microlaser pouvant être réalisée à l'aide d'un procédé selon l'invention est une structure comportant un milieu actif laser 134 (figure 14) compris entre un micromiroir d'entrée 141 et un miroir intermédiaire 135. Des moyens de déclenchement actifs 136 sont compris entre le miroir intermédiaire 135 et un miroir de sortie 139. Les micromiroirs 139, 141 sont réalisés sous forme de plaques sur un matériau 143 comme le verre ou la silice, transparent à la longueur d'onde du laser. Ces substrats comportant les micromiroirs peuvent être ensuite assemblés avec, d'une part, le milieu actif laser 134 et, d'autre part, l'élément de déclenchement actif 136 selon un des procédés décrits dans la présente demande. Sur la figure 14, les éléments 134, 136 ont été gravés de façon à réaliser des caissons dans lesquels des plots 142, 144, 146 en matériau fluable et mouillable sont incorporés et assurent la tenue mécanique entre les différents éléments du microlaser. La liaison d'un élément avec l'autre est assuré par contact intime, avec un excellent parallélisme.

Selon une variante, le dispositif de la figure 14 peut également être réalisé avec des joints disposés de manière transversale, obtenus par mise en oeuvre du procédé selon le premier mode de réalisation exposé ci-dessus.

Une autre structure de cavité microlaser pouvant être réalisée à l'aide d'un procédé selon l'invention est représentée schématiquement sur la figure 15. Elle comporte un milieu actif laser 152, des moyens 156 de déclenchement, en mode actif ou passif, de la cavité microlaser qui est limitée par des miroirs d'entrée et de sortie 148, 150. La cavité est pompée par des moyens optiques, non représentés sur la figure. Les impulsions émises par le microlaser sont absorbées par un élément semi-conducteur désigné par la référence 160. Le microlaser est une source compacte, robuste, intégrable pour réaliser une structure monolithique, et qui a suffisamment de puissance pour atteindre le seuil laser de n'importe quel semi-conducteur, même ceux qui ont des seuils très élevés, et ceci quelle que soit la température (par exemple, les semi-conducteurs PbₓSn₁₋ₓSe, PbₓSn₁₋ₓTe, PbS₁₋ₓSeₓ, CdₓPb₁₋ₓS, InAsₓSb₁₋ₓ, CdₓHg₁₋ₓTe, Bi₁₋ₓSbₓ, 0≤x≤1, tous ces composés permettant d'obtenir des longueurs d'onde λ≥1µm, mais, avec des moyens de pompage conventionnels, pour une température inférieure à 160K ; il en va de même pour les alliages du type InAsSb (InAsₓSb₁₋ₓ) sur substrat InAs).

L'élément semi-conducteur peut avoir la forme d'une lame ayant une épaisseur de quelques centaines de micromètres, ou bien faire partie d'un laser à semi-conducteur, par exemple du type VCSEL.

L'élément semi-conducteur 160 est relié à l'élément de déclenchement 156 par des plots 162 de matériau fluable et mouillable ; et il est en contact intime avec le miroir 150. Selon une variante, un joint de matériau fluable et mouillable assure à l'interface miroir-élément semi-conducteur, la liaison mécanique, tandis que les deux surfaces sont encore en contact via le joint.

On peut en effet obtenir en sortie du microlaser plusieurs kilowatts crêtes sur un diamètre de 20 à 100 µm, soit des densités de puissance de quelques dizaines de mégawatts par cm². Cette densité de puissance permet d'obtenir un effet laser, avec un pompage optique, pour la plupart des semi-conducteurs connus.

La puissance émise par le semi-conducteur est alors typiquement de l'ordre de plusieurs dizaines de milliwatts.

Par ailleurs, du fait des faibles longueurs de cavité des microlasers (inférieures ou égales à 1 mm), leurs impulsions sont brèves, typiquement moins de 1 nanoseconde, ou au plus 5 nanosecondes, ce qui permet d'éviter toute charge thermique nuisible au semi-conducteur.

D'une manière générale, dans les applications optiques ou optroniques, le matériau utilisé pour former les plots est choisi de préférence compatible optiquement, c'est-à-dire de manière à induire un minimum de perte optique sur les faisceaux. Ainsi, on choisit un matériau d'indice de réfraction le plus proche possible de celui des structures à assembler. C'est surtout le cas pour les structures obtenues à l'aide du premier mode de réalisation du procédé selon l'invention, c'est-à-dire dans le cas où on ne réalise pas de caisson où on peut introduire les joints en matériau fluable et mouillable. Dans le cas de l'utilisation d'un matériau en silice (Sol-Gel de silice), l'indice de réfraction peut être ajusté par dopage (par exemple avec des oxynitrures SiOₓN_{y}) : ainsi, on adapte au mieux le saut d'indice à l'interface des matériaux en présence et on peut réduire d'autant les pertes optiques.

## Revendications

1. Procédé d'assemblage de deux structures (2,4), comportant :
- la formation, sur au moins une des structures (4), de plots (12,14,16) en un matériau fluable et mouillable sur les deux structures (2,4), par dépôt d'une couche (10) dudit matériau et gravure de ce dernier,
- le positionnement des deux structures (2,4) de manière à ce que les plots se trouvent à leur interface,
- l'assemblage des deux structures (2,4) par chauffage des plots (12,14,16), pour les faire fluer, de façon à obtenir un joint continu, et la réalisation d'un contact intime des deux structures.

2. Procédé d'assemblage de deux structures (2,4), comportant :
- la formation d'au moins un plot espaceur (31,33,35,37) dans une première des deux structures, ce(s) plot(s) espaceur(s) définissant, sur ses bords, un, ou des, caisson(s) latéral (latéraux) (23,25,27,29), chaque caisson latéral présentant un fond,
- la formation, sur le fond d'au moins un caisson latéral (23,25,27,29), d'un joint (32,34,36) en un matériau fluable et mouillable sur les deux structures (2,4),
- le positionnement des deux structures (2,4) de manière à ce que le joint (32,34,36) se trouve à leur interface,
- l'assemblage des deux structures (2,4) chauffage des joints (32,34,36), pour les faire fluer, et la réalisation d'un contact intime des deux structures (2,4).

3. Procédé selon la revendication 2, au moins un plot espaceur étant également formé dans la deuxième structure (2), ce(s) plot(s) espaceur(s) définissant, sur ses bords, un, ou des, caisson(s) latéral (latéraux), chaque caisson latéral présentant un fond, le positionnement des deux structures étant réalisé de manière à ce qu'un plot espaceur de la première structure (4) soit situé en regard d'un plot espaceur de la deuxième structure (2).

4. Procédé d'assemblage de deux structures (2,4), comportant :
- la formation d'au moins un plot espaceur dans une première des deux structures (4), ce(s) plot(s) espaceur(s) définissant, sur ses bords, un, ou des, caisson(s) latéral (latéraux) (21,23,25,27,29), chaque caisson latéral présentant un fond,
- la formation, sur la deuxième structure (2), d'au moins un joint (62,64,66) en un matériau fluable et mouillable sur les deux structures (2,4),
- le positionnement des deux structures (2,4) de manière à ce que chaque joint de la deuxième structure (2) soit introduit dans un caisson (21,23,25,27,29) de la première structure (4),
- l'assemblage des deux structures par chauffage des joints, pour les faire fluer, et la réalisation d'un contact intime des deux structures.

5. Procédé selon l'une des revendications 1 à 4, le matériau fluable et mouillable étant une résine photosensible ou un matériau fusible du type Sol Gel de silice (SOG) ou un alliage métallique In ou Pb-Sn.

6. Procédé selon l'une des revendication 1 à 4, le matériau fluable et mouillable étant une résine négative.

7. Procédé selon l'une des revendications 1 à 6, le chauffage des plots et le rapprochement des deux structures ayant lieu par pression à chaud des deux structures.

8. Procédé selon l'une des revendications 1 à 7, comportant ensuite une étape de découpe des deux structures (2,4) assemblées.

9. Assemblage d'une première et d'une seconde structure (2,4) ayant chacune au moins une face plane (6,8), ces deux faces planes étant en contact intime, un joint continu en un matériau fluable et mouillable étant situé à l'interface entre les deux faces planes.

10. Assemblage d'une première et d'une seconde structure (2,4) ayant chacune au moins une face plane, l'une d'elle comportant en outre au moins un caisson latéral (21,23,25,27,29) présentant un fond en retrait par rapport à la face plane, les deux faces planes étant en contact intime, un joint de collage en un matériau fluable et mouillable étant disposé dans au moins un caisson latéral (21,23,25,27,29), et reliant les deux structures.

11. Assemblage d'une première et d'une seconde structure (2,4) selon l'une des revendication 9 ou 10, le matériau fluable et mouillable étant une résine photosensible, ou en un matériau fusible du type Sol Gel de silice (SOG) ou en un alliage métallique In ou PbSn.

12. Assemblage d'une première et d'une seconde structure (2,4) selon l'une des revendications 9 ou 10, le matériau fluable et mouillable étant une résine négative.

13. Assemblage selon l'une des revendications 9 à 12, les première et seconde structures (2,4) étant respectivement un milieu actif solide (102) pour cavité microlaser et un absorbant saturable (110) pour cavité microlaser.

14. Assemblage selon la revendication 13, le milieu actif solide (102) étant un verre dopé à l'erbium (Er) ou à l'ytterbium (Yb).

15. Assemblage selon l'une des revendications 9 à 12, les première et seconde structures (2,4) étant respectivement un milieu actif solide (116) pour cavité microlaser et un élément en un matériau optiquement non linéaire (124).

16. Assemblage selon l'une quelconque des revendications 9 à 12, les première et seconde structures (2,4) étant respectivement un milieu actif solide pour cavité microlaser et un composant microoptique.

17. Assemblage selon l'une quelconque des revendications 9 à 12, les première et seconde structures (2, 4) étant respectivement deux composants microoptiques.

18. Assemblage selon l'une quelconque des revendications 16 et 17, **caractérisé par le fait que** le ou les composants microoptiques sont des microprismes ou des micromiroirs (77,80,82,83).

19. Assemblage selon la revendication 15, l'élément optiquement non linéaire (104) étant soit un élément permettant de multiplier la fréquence de base par un nombre entier n (n≥2) soit un oscillateur paramétrique optique.

20. Cavité microlaser comportant un assemblage selon l'une des revendications 13 à 19, ainsi qu'un miroir d'entrée (106) et un miroir de sortie (108).

21. Assemblage pour cavité microlaser selon l'une des revendications 9 à 12, les première et seconde structures (2,4) comportant respectivement d'une part, un milieu actif solide (75), avec un miroir intermédiaire plan (85) disposé sur une face plane du milieu actif laser (75), et d'autre part un élément (81) en un matériau dont l'indice optique est apte à être modulé par une perturbation extérieure, cet élément (81) présentant une face plane, cette dernière étant en contact intime avec le miroir intermédiaire (85).

22. Assemblage pour microlaser selon la revendication 21, l'élément (81) à indice modulable étant un élément électrooptique.

23. Cavité microlaser comportant un assemblage pour microlaser selon l'une des revendications 21 ou 22, ainsi qu'un miroir d'entrée (77) et un miroir de sortie (83).

24. Dispositif pour émetteur de lumière infrarouge comportant un assemblage selon l'une des revendications 9 à 12, la première et la deuxième structures étant respectivement :
- un élément semi-conducteur, apte à émettre un rayonnement infrarouge,
- une cavité microlaser incorporant des moyens de déclenchement, disposée de manière à pouvoir pomper optiquement l'élément semi-conducteur.

## Patentansprüche

1. Verfahren zum Verbinden zweier Strukturen (2, 4), umfassend:
- das Ausbilden von Höckern (12, 14, 16) aus einem fließfähigen und auf den beiden Strukturen (2, 4) benetzungsfähigen Material auf wenigstens einer der Strukturen (4) durch Abscheidung einer Schicht (10) des genannten Materials und dessen Ätzung,
- das Anordnen der beiden Strukturen (2, 4) derart, daß sich an ihrer Grenzfläche die Höcker befinden,
- das Verbinden der beiden Strukturen (2, 4) durch Erwärmen der Höcker (12, 14, 16), um sie zum Fließen zu bringen, so daß eine zusammenhängende Verbindung erhalten wird, und die Herstellung eines innigen Kontakts der beiden Strukturen.

2. Verfahren zum Verbinden zweier Strukturen (2, 4), umfassend:
- das Ausbilden wenigstens eines Abstandshöckers (31, 33, 36, 37) in einer ersten der beiden Strukturen, wobei dieser oder diese Höcker an ihren Rändern einen oder mehrere seitliche Kästen (23, 25, 27, 29) festlegen und jeder seitliche Kasten einen Boden aufweist,
- das Ausbilden eines Verbindungsstücks (32, 34, 36) aus einem fließfähigen und auf den beiden Strukturen (2, 4) benetzungsfähigen Materials auf dem Boden wenigstens eines seitlichen Kastens (23, 25, 27, 29),
- das Anordnen der beiden Strukturen (2, 4) derart, daß sich an ihrer Grenzfläche das Verbindungstück (32, 34, 36) befindet,
- das Verbinden der beiden Strukturen (2, 4) durch Erwärmen der Verbindungsstücke (32, 34, 36), um sie zum Fließen zu bringen, und die Herstellung eines innigen Kontakts der beiden Strukturen (2, 4).

3. Verfahren nach Anspruch 2, wobei in der zweiten Struktur (2) ebenfalls wenigstens ein Abstandshöcker ausgebildet wird, dieser oder diese Abstandshöcker an ihren Rändern einen oder mehrere seitliche Kästen festlegen und jeder seitliche Kasten einen Boden aufweist und wobei das Anordnen der beiden Strukturen derart ausgeführt wird, daß ein Abstandshöcker der ersten Struktur (4) sich gegenüber einem Abstandshöcker der zweiten Struktur (2) befindet.

4. Verfahren zum Verbinden zweier Strukturen (2, 4), umfassend:
- das Ausbilden wenigstens eines Abstandshöckers in einer ersten der beiden Strukturen (4), wobei dieser oder diese Abstandshöcker an ihren Rändern einen oder mehrere seitliche Kästen (21, 23, 25, 27, 29) festlegen und jeder seitliche Kasten einen Boden aufweist,
- das Ausbilden wenigstens eines Verbindungsstücks (62, 64, 66) aus einem fließfähigen und auf den beiden Strukturen (2, 4) benetzungsfähigen Material auf der zweiten Struktur (2),
- das Anordnen der beiden Strukturen (2, 4) derart, daß jedes Verbindungsstück der zweiten Struktur (2) in einen Kasten (21, 23, 25, 27, 29) der ersten Struktur (4) gebracht wird,
- das Verbinden der beiden Strukturen durch Erwärmen der Verbindungsstücke, um sie zum Fließen zu bringen, und die Herstellung eines innigen Kontakts der beiden Strukturen.

5. Verfahren nach einem der Ansprüche 1 bis 4, wobei das fließfähige und benetzungsfähige Material ein lichtempfindliches Harz oder ein schmelzbares Material vom Typ Siliciumdioxid-Sol-Gel (SOG) oder eine metallische In- oder Pb-Sn-Legierung ist.

6. Verfahren nach einem der Ansprüche 1 bis 4, wobei das fließfähige und benetzungsfähige Material ein negatives Harz ist.

7. Verfahren nach einem der Ansprüche 1 bis 6, wobei das Erwärmen der Höcker und die Annäherung der beiden Strukturen durch Pressen der beiden Strukturen in der Wärme stattfindet.

8. Verfahren nach einem der Ansprüche 1 bis 7, anschließend einen Schritt des Zerschneidens der beiden verbundenen Strukturen (2, 4) umfassend.

9. Verband aus einer ersten und einer zweiten Struktur (2, 4), die beide wenigstens eine ebene Seite (6, 8) haben, wobei diese beiden ebenen Seiten in innigem Kontakt sind, während ein zusammenhängendes Verbindungsstück aus einem fließfähigen und benetzungsfähigen Material sich an der Grenzfläche zwischen den beiden ebenen Seiten befindet.

10. Verband aus einer ersten und einer zweiten Struktur (2, 4), die beide wenigstens eine ebene Seite haben, wobei die eine von ihnen ferner wenigstens einen seitlichen Kasten (21, 23, 25, 27, 29) enthält, der einen gegenüber der ebenen Seite zurückgesetzten Boden aufweist, die beiden ebenen Seiten in innigem Kontakt sind und ein Klebe-Verbindungsstück aus einem fließfähigen und benetzungsfähigen Material in wenigstens einem seitlichen Kasten (21, 23, 25, 27, 29) angebracht ist, das die beiden Strukturen verbindet.

11. Verband aus einer ersten und einer zweiten Struktur (2, 4) nach einem der Ansprüche 9 und 10, wobei das fließfähige und benetzungsfähige Material ein lichtempfindliches Harz oder aus einem schmelzbaren Material vom Typ Siliciumdioxid-Sol-Gel (SOG) oder aus einer metallischen In- oder Pb-Sn-Legierung ist.

12. Verband aus einer ersten und einer zweiten Struktur (2, 4) nach einem der Ansprüche 9 und 10, wobei das fließfähige und benetzungsfähige Material ein negatives Harz ist.

13. Verband nach einem der Ansprüche 9 bis 12, wobei die erste und die zweite Struktur (2, 4) ein aus einem Festkörper bestehendes aktives Medium (102) für einen Mikrolaser-Hohlraumresonator bzw. ein sättigungsfähiges Absorbens (110) für einen Mikrolaser-Hohlraumresonator sind.

14. Verband nach Anspruch 13, wobei das aus einem Festkörper bestehende aktive Medium (102) ein mit Erbium (Er) oder mit Ytterbium (Yb) dotiertes Glas ist.

15. Verband nach einem der Ansprüche 9 bis 12, wobei die erste und die zweite Struktur (2, 4) ein aus einem Festkörper bestehendes aktives Medium (116) für einen Mikrolaser-Hohlraumresonator bzw. ein Element aus einem optisch nichtlinearen Material (124) sind.

16. Verband nach einem der Ansprüche 9 bis 12, wobei die erste und die zweite Struktur (2, 4) ein aus einem Festkörper bestehendes aktives Medium für einen Mikrolaser-Hohlraumresonator bzw. ein mikrooptisches Bauelement sind.

17. Verband nach einem der Ansprüche 9 bis 12, wobei die erste und die zweite Struktur (2, 4) beide jeweils ein mikrooptisches Bauelement sind.

18. Verband nach einem der Ansprüche 16 und 17, durch den Umstand gekennzeichnet, daß das oder die mikrooptischen Bauelemente Mikroprismen oder Mikrospiegel (77, 80, 82, 83) sind.

19. Verband nach Anspruch 15, wobei das optisch nichtlineare Element (104) entweder ein Element, das erlaubt, die Basisfrequenz mit einer ganzen Zahl n (n≥2) zu multiplizieren, oder ein optischer parametrischer Oszillator ist.

20. Mikrolaser-Hohlraumresonator, umfassend einen Verband nach einem der Ansprüche 13 bis 19 sowie einen Eintrittsspiegel (106) und einen Austrittsspiegel (108).

21. Verband für einen Mikrolaser-Hohlraumresonator nach einem der Ansprüche 9 bis 12, wobei die erste und die zweite Struktur (2, 4) einerseits ein aus einem Festkörper bestehendes aktives Medium (75) mit einem ebenen Zwischenspiegel (85), der auf einer ebenen Seite des laseraktiven Mediums (75) angeordnet ist, bzw. andererseits ein Element (81) aus einem Material, dessen optischer Index durch eine äußere Störung modulierbar ist, umfassen, wobei dieses Element (81) eine ebene Seite aufweist und diese in innigem Kontakt mit dem Zwischenspiegel (85) ist.

22. Verband für einen Mikrolaser nach Anspruch 21, wobei das Element (81) mit modulierbarem Index ein elektrooptisches Element ist.

23. Mikrolaser-Hohlraumresonator, umfassend einen Verband für einen Mikrolaser nach einem der Ansprüche 21 oder 22 sowie einen Eintrittsspiegel (77) und einen Austrittsspiegel (83).

24. Vorrichtung für einen Sender von infrarotem Licht, umfassend einen Verband nach einem der Ansprüche 9 bis 12, wobei die erste und die zweite Struktur sind:
- ein Halbleiter-Element, das geeignet ist, eine infrarote Strahlung auszusenden,
bzw.
- ein Mikrolaser-Hohlraumresonator, Einrichtungen zum Auslösen aufnehmend, der derart angeordnet ist, daß man das Halbleiter-Element optisch pumpen kann.

## Claims

1. Procedure for assembling two structures (2, 4) comprising:
- formation on at least one of the structures (4) of studs (12, 14, 16) of a fluidizable, wettable material on the two structures (2, 4) by depositing a layer (10) of said material and etching of the same,
- positioning of the two structures (2, 4) so that the studs are at the interface,
- assembly of the two structures (2, 4) by heating the studs (12, 14, 16) causing them to flow in order to obtain a continuous joint, and by bringing about an intimate contact of the two structures.

2. Procedure for assembling two structures (2, 4) comprising:
- formation of at least one spacer stud (31, 33, 35, 37) in the first of the two structures, the edges of said spacer stud(s) defining one or more lateral notches (23, 25, 27, 29), each lateral notch presenting a bottom,
- the creation on the bottom of at least one lateral notch (23, 25, 27, 29) of a joint (32, 34, 36) made of a material that is fluidizable and wettable on the two structures (2, 4),
- positioning of the two structures such that said joints (32, 34, 36) is at the interface,
- assembly of said structures (2, 4) by heating the joints (32, 34, 36) causing them to flow, and by bringing about an intimate contact of the two structures (2, 4).

3. Procedure of claim 2, wherein at least one spacer stud is also created in the second structure (12), the edges of said spacer stud(s) defining one or more lateral notches, each lateral notch presenting a bottom, the positioning of the two structures being such that a spacer stud of the first structure (4) is located facing a spacer stud of the second structure (2).

4. Procedure for assembling two structures comprising:
- formation of at least one spacer stud in the first of the two structures (4), the edges of said spacer stud(s) defining one or more lateral notches (21, 23, 25, 27, 29), each lateral notch presenting a bottom,
- the creation on the second structure (2) of at least one joint (62, 64, 66) made of a fluidizable, wettable material on the two structures (2, 4),
- positioning of the two structures (2, 4) such that each joint of the second structure (2) is inserted into a notch (21, 23, 25, 27, 29) in the first structure (4),
- assembly of the two structures by heating the joints causing them to flow for bringing about an intimate contact between the two structures.

5. Procedure according to one of the claims 1 to 4, wherein the fluidizable, wettable material is a photosensitive resin or a meltable material of the sol gel silica (SOG) type, or an In or Pb-Sn metal alloy.

6. Procedure according to one of the claims 1 to 4, in which the fluidizable, wettable material is a negative resin.

7. Procedure according to one of the claims 1 to 6, in which the heating of the studs and bringing the two structures together takes place by heating the two structures under pressure.

8. Procedure according to one of the claims 1 to 7, comprising a subsequent stage in which the two assembled structures (2, 4) are cut.

9. Assembly of a first and second structure (2, 4) each having at least one plane surface (6, 8), said plane surfaces being in intimate contact, a continuous joint made of a fluidizable, wettable material being located at the interface between said plane surfaces.

10. Assembly of a first and second structure (2, 4) each having at least one plane surface, one of which also comprises at least one lateral notch (21, 23, 25, 27, 29) having a bottom set back from the plane surface, the two plane surfaces being in intimate contact, an adhesive joint made of a fluidizable, wettable material being disposed in at least one lateral notch (21, 23, 25, 27, 29) and connecting the two structures.

11. Assembly of a first and second structure (2, 4) according to claim 9 or 10, the fluidizable, wettable material being a photosensitive resin or a meltable material of the sol gel silica (SOG) type, or an In or Pb-Sn metal alloy.

12. Assembly of a first and second structure (2, 4) according to claim 9 or 10, the fluidizable, wettable material being a negative resin.

13. Assembly according to one of the claims 9 to 12, the first and second structures (2, 4) being respectively a solid active medium (102) for a microlaser cavity and a saturable absorber (110) for a microlaser cavity.

14. Assembly according to claim 13, wherein the solid active medium (102) is glass doped with erbium (Er) or ytterbium (Yb).

15. Assembly according to one of the claims 9 to 12, wherein the first and second structures (12, 4) are respectively a solid active medium (116) for a microlaser cavity and a component (124) made of an optically non-linear materal.

16. Assembly according to one of the claims 9 to 12, wherein the first and second structures (2, 4) are respectively a solid active medium for a microlaser cavity and a micro-optical component.

17. Assembly according to one of the claims 9 to 12, wherein the first and second structures (2, 4) are respectively two micro-optical components.

18. Assembly according to one of the claims 16 and 17, wherein the micro-optical component or components are microprisms or micromirrors (77, 80, 82, 83).

19. Assembly according to claim 15, wherein the non-linear optical component (104) is either a component able to multiply the basic frequency by a whole number n (n ≥ 2) or an optical parametric oscillator.

20. Microlaser cavity comprising an assembly according to one of the claims 13 to 19, as well as an entrance mirror (106) and an exit mirror (108).

21. Assembly for microlaser cavity according to one of the claims 9 to 12, wherein the first and second structures (2, 4) comprise respectively a solid active medium (116) with a plane intermediate mirror (85) disposed on one plane surface of the active laser medium (75), and a component (81) made of a material whose optical index can be modulated by outside perturbation, this component (81) having a plane surface that is in intimate contact with the intermediate mirror (85).

22. Microlaser assembly according to claim 21, the modulable index component (81) being an electro-optical component.

23. Microlaser cavity comprising an assembly for a microlaser according to one of the claims 21 or 22, as well as an entrance mirror (77) and an exit mirror (83).

24. Apparatus for infrared light emitter comprising an assembly according to one of the claims 9 to 12, in which the first and second structures are, respectively:
- a semiconductor component cable of emitting infrared radiation,
- a microlaser cavity incorporating switching means disposed to be capable of optically pumping the semiconductor component.
